(19) Europäisches Patentamt
European Patent Office
Office européen des brevets

(11) Veröffentlichungsnummer: **0 011 786**
**B1**

(12) # EUROPÄISCHE PATENTSCHRIFT

(45) Veröffentlichungstag der Patentschrift: **19.01.83**

(51) Int. Cl.³: **G 03 C 1/68**, C 08 F 2/50

(21) Anmeldenummer: **79104548.7**

(22) Anmeldetag: **16.11.79**

(54) **Photopolymerisierbares Gemisch.**

(30) Priorität: **22.11.78 DE 2850585**

(43) Veröffentlichungstag der Anmeldung: **11.06.80 Patentblatt 80/12**

(45) Bekanntmachung des Hinweises auf die Patenterteilung: **19.01.83 Patentblatt 83/3**

(84) Benannte Vertragsstaaten: **AT BE DE FR GB IT NL SE**

(56) Entgegenhaltungen: **US-A-3 729 313**

(73) Patentinhaber: **HOECHST AKTIENGESELLSCHAFT, Postfach 80 03 20, D-6230 Frankfurt/Main 80 (DE)**

(72) Erfinder: **Klüpfel, Kurt, Dr., Dreispitzstrasse 2a, D-6200 Wiesbaden-Sonnenberg (DE)**

EP 0 011 786 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

Photopolymerisierbares Gemisch

Die Erfindung betrifft ein neues photopolymerisierbares Gemisch, das als wesentliche Bestandteile mindestens ein Bindemittel, mindestens eine polymerisierbare Verbindung und mindestens einen Photoinitiator enthält.

Aus der DE-C-2 027 467 sind bestimmte Derivate des Acridins und Phenazins als Photoinitiatoren bekannt.

In der DE-C-2 039 861 sind für den gleichen Zweck Derivate des Chinoxalins und Chinazolins beschrieben.

In der US-A-3 729 313 sind als Sensibilisatoren für photopolymerisierbare Gemische im sichtbaren Spektralbereich bestimmte Farbstoffe beschrieben, darunter das 2-(4-Dimethylamino-styryl)chinolin. Diese Verbindungen sind selbst keine Radikalinitiatoren und werden immer in Kombination mit Diaryljodoniumverbindungen angewendet.

Aufgabe der Erfindung war es, weitere hochwirksame Photoinitiatoren zur Verfügung zu stellen.

Die Erfindung geht aus von einem photopolymerisierbaren Gemisch, das ein polymeres Bindemittel, eine polymerisierbare Verbindung mit mindestens einer endständigen äthylenischen Doppelbindung und einem Siedepunkt oberhalb 100°C sowie eine mehrkernige heterocyclische Verbindung als Photoinitiator enthält.

Das erfindungsgemäße Gemisch ist dadurch gekennzeichnet, daß der Photoinitiator eine Verbindung der Formel

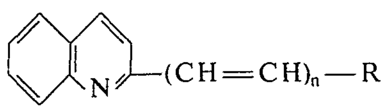

ist, worin

R ein gegebenenfalls durch Alkoxy-, Alkyl-, Aryl-, Hydroxy-, Carbonsäureamidgruppen oder Halogenatome substituierter aromatischer Rest und
n 1 oder 2

ist.

Die in dem erfindungsgemäßen Gemisch enthaltenen Photoinitiatoren absorbieren Licht im Spektralbereich von etwa 250 bis 395 nm und wirken bei Bestrahlung in diesem Spektralbereich als aktive Radikalstarter für die Photopolymerisation von Vinylverbindungen, auch in Gegenwart von Sauerstoff. Die neuen Photoinitiatoren haben zugleich die Eigenschaft, die thermische Polymerisation solcher Verbindungen in Abwesenheit von aktinischer Strahlung zu hemmen. Sie sind somit ideal zur Herstellung lagerfähiger photopolymerisierbarer Gemische geeignet. Die damit hergestellten Gemische zeichnen sich ferner durch ihre gute Rasterwiedergabe aus.

Von den Substituenten im aromatischen Rest R haben aliphatische Substituenten im allgemeinen 1–6, bevorzugt 1–3 C-Atome, Substituenten, die aromatische Reste enthalten, im allgemeinen 6–10 C-Atome.

Der aromatische Rest kann ein carbo- oder heterocyclischer ein- oder mehrkerniger aromatischer Rest sein, der auch angeschlossene hydrierte Ringe enthalten kann. Vorzugsweise enthält der aromatische Rest nicht mehr als drei Ringe. Als besonders wirksame Verbindungen haben sich 4-Methoxy-Benzalchinaldin, 4-Methyl-Benzalchinaldin, 4-Chlor-Benzalchinaldin, 2-(4-Phenyl)-butadienyl)-chinolin, 2-(2-Phenanthryl-(3-vinyl)-chinolin und 2-(2-Benzo[2]thienyl-(3)-vinyl)-chinolin bewährt.

Die Initiatoren werden im allgemeinen in einer Konzentration von 0,01 bis 10, vorzugsweise von 0,2 bis 7 Gew.-%, bezogen auf das Gewicht der polymerisierbaren Verbindungen, angewendet.

Viele der hier als Photoinitiatoren verwendeten Verbindungen sind aus der Literatur bekannt. Der aktive Wasserstoff der Methylgruppe des 2-Methyl-chinolins erlaubt eine einfache Kondensation mit aromatischen Aldehyden bei ca. 150°C unter Wasserabspaltung zu den gesuchten Benzalchinaldinen und ihren Derivaten bzw. Homologen.

Als polymerisierbare Verbindungen sind Verbindungen mit endständigen Vinyl- oder Vinylidengruppen geeignet, die zur radikalisch initiierten Kettenpolymerisation befähigt sind. Unter diesen sind die Acryl- und Methacrylsäurederivate, insbesondere die Ester, besonders gut geeignet. Verbindungen mit mindestens zwei polymerisierbaren Gruppen werden besonders bevorzugt.

Beispiele für geeignete Verbindungen sind die Acryl- und Methacrylsäureester von Äthylenglykol, Polyäthylenglykol, Trimethylolpropan, Pentaerythrit, Dipentaerythrit und ähnlichen mehrwertigen Alkoholen. Besonders gut geeignet sind auch polymerisierbare Verbindungen mit zwei oder mehreren Urethangruppen im Molekül, wie sie z. B. in den DE-OS 2 064 079 und 2 361 041 sowie der nicht vorveröffentlichten DE-A-2 822 190 beschrieben sind.

Die polymerisierbaren Verbindungen werden im allgemeinen in einer Menge von 10 bis 70, vorzugsweise 20 bis 50 Gew.-%, bezogen auf die Gesamtmenge der nichtflüchtigen Bestandteile des

Gemischs, verwendet.

Die photopolymerisierbaren Gemische können in bekannter Weise ein oder mehrere Bindemittel enthalten, z. B. in Lösungsmitteln lösliche Polyamide, Polyvinylacetate, Polymethylmethacrylate, Polyvinylacetale, ungesättigte Polyester, in wäßrigem Alkali lösliche oder quell- bzw. erweichbare Polymere, wie Styrol/Maleinsäureanhydrid-Mischpolymerisate, Maleinatharze u. dgl. mehr. Da die Entwicklung häufig mit wäßrig-alkalischen Entwicklern durchgeführt wird, werden vorzugsweise Bindemittel verwendet, die alkalilöslich oder in wäßrigen Alkalien erweichbar sind. Beispiele für solche Bindemittel sind Mischpolymerisate von Styrol und Maleinsäureanhydrid von Vinylacetat und Crotonsäure und von Alkylacrylaten oder -methacrylaten mit Acryl- oder Methacrylsäure. Besonders gut eignen sich Mischpolymerisate der Methacrylsäure, z. B. Terpolymerisate mit höheren Alkylmethacrylaten und weiteren Monomeren, wie sie in den DE-A-2 064 080 und 2 363 806 beschrieben sind.

Die Bindemittel sind in dem Gemisch im allgemeinen in einer Menge von 20 bis 80, bevorzugt von 35 bis 65 Gew.-%, bezogen auf die Menge der nichtflüchtigen Bestandteile, enthalten.

Den Gemischen können ferner Farbstoffe, Pigmente, Polymerisationsinhibitoren, Farbbildner und Wasserstoffdonatoren zugesetzt werden. Diese Zusätze sollten jedoch vorzugsweise keine übermäßigen Mengen des für den Initiierungsvorgang notwendigen aktinischen Lichts absorbieren. Als Wasserstoffdonatoren sind in bekannter Weise z. B. Substanzen mit aliphatischen Ätherbindungen geeignet. Gegebenenfalls kann diese Funktion auch vom Bindemittel oder der polymerisierbaren Substanz übernommen werden, so daß dann auf zusätzliche Wasserstoffdonatoren verzichtet werden kann.

Die erfindungsgemäßen Gemische können zur Verbesserung der Elastizität auch Weichmacher wie Polyglykole, Ester der p-Hydroxybenzoesäure usw. enthalten.

Die Gemische finden bevorzugte Anwendung bei der Herstellung von Hochdruckformen, Reliefbildern, Offsetdruckformen, Bimetall- sowie Trimetalldruckformen, kopierten Schaltungen, Siebdruckschablonen und Druckformen für den rasterlosen Offsetdruck.

Wenn das Gemisch in flüssiger Form als sogenannter Kopierlack aufbewahrt und erst unmittelbar vor der Anwendung auf die Unterlage, z. B. einen Siebdruckträger, eine Leiterplatte od. dgl., aufgebracht werden soll, werden die Schichtbestandteile in einem geeigneten Lösungsmittel bzw. Lösungsmittelgemisch gelöst oder dispergiert. Als Lösungsmittel sind Alkohole, Ketone, Ester, Äther, Amide, Kohlenwasserstoffe u. dgl. geeignet. Vor allem werden die Partialäther mehrwertiger Alkohole, insbesondere der Glykole, verwendet.

Die Gemische können für die Herstellung von Druckplatten usw. mit Vorteil unmittelbar nach ihrer Herstellung auf einen geeigneten Träger aufgebracht und als lichtempfindliche Kopiermaterialien aufbewahrt und in den Handel gebracht werden. Hierbei können die gleichen oder ähnliche Lösungsmittel wie für die Herstellung der Kopierlacke verwendet werden. Der Antrag erfolgt z. B. durch Gießen, Sprühen, Eintauchen oder Walzen.

Als Schichtträger eignen sich z. B. Zink, Kupfer, Aluminium, Stahl, Polyester- bzw. Acetatfolie, Perlongaze etc., deren Oberfläche bei Bedarf einer Vorbehandlung unterworfen sein kann.

Erforderlichenfalls wird zwischen Träger und lichtempfindlicher Schicht eine haftvermittelnde Zwischenschicht bzw. eine Lichthofschutzschicht aufgebracht.

Für die Herstellung dicker Photopolymerschichten, deren Stärke einige Zehntel mm betragen kann, kann die erfindungsgemäße Kopiermasse auch ohne Auflösen in einem Lösungsmittel, z. B. im Dreiwalzenstuhl, verknetet und auf die Trägerfolie hydraulisch aufgepreßt werden.

Die Druckformen, Ätzreserven, Siebdruckformen etc. werden aus den geeigneten Materialien auf die in der Praxis üblichen Weise hergestellt, d. h. nach der Belichtung unter einer Vorlage werden die nicht gehärteten Nichtbildstellen durch Behandeln mit geeigneten Lösungsmitteln bzw. wäßrig-alkalischen Lösungen entfernt.

Tabelle I

Allgemeine Formel:

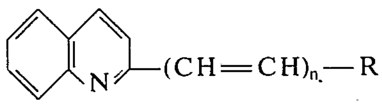

| Verbindung Nr. | FP °C | λ max nm | Fluoreszenz 366 nm | n | R |
|---|---|---|---|---|---|
| 1 | 98 | 286<br>(345) | blau | 1 | Phenyl |
| 2 | 124–125 | 359 | stark blau | 1 | 4-Methoxy-phenyl |
| 3 | 103–104 | 362 | stark blau | 1 | 3,4-Dimethoxy-phenyl |
| 4 | 126–127 | 344 | grüngelb | 1 | 4-Methyl-phenyl |
| 5 | 78 | 285<br>(330) | blau | 1 | 2-Chlor-phenyl |
| 6 | 94–95 | 283<br>(346) | blau-violett | 1 | 3-Chlor-phenyl |
| 7 | 143 | 287<br>(342) | blau | 1 | 4–Chlor-phenyl |
| 8 | 118 | 357 | stark blau | 2 | Phenyl |
| 9 | 136 | 372 | intensiv gelbgrün | 2 | 4-Methoxy-phenyl |
| 10 | 93–94 | 305<br>(352) | grüngelb | 1 | Naphthyl-(1) |
| 11 | 185 | 253<br>(395) | intensiv gelb | 1 | Anthryl-(9) |
| 12 | 153 | 275<br>(358) | hellgelb | 1 | Phenanthryl-(3) |
| 13 | 200 | 360 | ockergelb | 1 | Fluorenyl-(2) |
| 14 | 280 | 375 | intensiv grüngelb | 1 | Diphenyl-(4) |
| 15 | 132–133 | 264<br>362 | grüngelb | 1 | Acenaphthyl-(5) |
| 16 | 59–61 | 357 | gelb | 1 | Benzo-[2]-thienyl-(3) |
| 17 | 57–59 | 352 | schwachgelb | 1 | Furyl-(2) |
| 18 | 88–90 | 270<br>(344) | hellgelb | 1 | Pyridyl-(2) |
| 19 | 221–223 | 256<br>(370) | gelbgrau | 1 | 2-Hydroxy-naphthyl-(1) |
| 20 | 155–157 | – | ockergelb | 1 | 2-Hydroxy-3-anilido-carbonyl-napthyl-(1) |

Die Darstellung der Benzalchinaldine wird in den Berichten der Deutschen Chem. Gesellschaft beschrieben (Ber. 36, 1666, Ber. 39, 2750 und Ber. 59, 1013).

Die nicht in der Literatur beschriebenen Benzalchinaldine und ihre Homologen wurden einer Stickstoff-Analyse unterworfen.

Die berechneten und gefundenen Stickstoffwerte für diese neuen unter den Verbindungen der Tabelle 1 zeigt die Tabelle Ia.

Tabelle I a

| | Verbindung Nr. | | | | | | | |
|---|---|---|---|---|---|---|---|---|
| | 2 | 3 | 4 | 9 | 10 | 11 | 12 | 13 |
| N ber. | 5,36 | 4,81 | 5,72 | 4,87 | 4,96 | 4,23 | 4,23 | 4,54 |
| N gef. | 5,20 | 4,80 | 5,80 | 4,82 | 5,00 | 4,21 | 4,20 | 4,32 |

| | Verbindung Nr. | | | | | | |
|---|---|---|---|---|---|---|---|
| | 14 | 15 | 16 | 17 | 18 | 19 | 20 |
| N ber. | 6,08 | 4,56 | 4,84 | 6,33 | 12,10 | 4,70 | 6,72 |
| N gef. | 6,02 | 4,40 | 4,62 | 6,35 | 12,06 | 4,76 | 7,20 |

Die Starteraktivität der Initiatoren der Formeln 1 – 20 ist in Tabelle II von Beispiel 1 zusammengefaßt.

In Beispiel 2 werden einige Photoinitiatoren aus Tabelle I in größerer Menge zugesetzt und die Lichtempfindlichkeit in voll vernetzten Keilstufen angegeben.

In den Beispielen 3 – 6 werden andere Photopolymerschichten und andere Anwendungsmöglichkeiten beschrieben.

Die Mengen der Bestandteile sind in Gewichtsteilen (Gt) angegeben. Wenn nichts anderes angegeben ist, sind Mengenverhältnisse und Prozentzahlen in Gewichtseinheiten zu verstehen.

Beispiel 1

20 Lösungen von jeweils

| | |
|---|---|
| 5,6 Gt | des Umsetzungsproduktes aus<br>1 Mol 2,2,4-Trimethyl-hexamethylen-diisocyanat und<br>2 Mol 2-Hydroxy-äthylmethacrylat, |
| 6,5 Gt | eines Terpolymerisats aus Styrol, n-Hexyl-methacrylat und Methacrylsäure (10 : 60 : 30) mit der Säurezahl 190, |
| 0,2 Gt | Photoinitiator (siehe Tabelle II), |
| 0,15 Gt | Triäthylenglykol-dimethacrylat und |
| 0,035 Gt | eines blauen Azofarbstoffes, erhalten durch Kuppeln von 2,4-Dinitro-6-chlorbenzoldiazoniumsalz mit 2-Methoxy-5-acetylamino-N-cyanoäthyl-N-hydroxyäthylanilin, in |
| 30 Gt | Butanon und |
| 0,5 Gt | Äthylalkohol |

werden nacheinander auf 25 µm starke Polyäthylenterephthalatfolie aufgeschleudert. Anschließend wird 2 Minuten bei 100°C im Trockenschrank nachgetrocknet. Es werden 25 µm (30 g/m²) dicke Schichten erhalten.

Um die erhaltenen Schichten vor Verschmutzung durch Staub und Beschädigungen zu schützen, werden sie mit einer 20 – 25 µm starken Deckfolie aus Polyäthylen, die an der Schicht weniger stark haftet als die Polyester-Trägerfolie, abgedeckt. Sie können so über einen längeren Zeitraum unter Lichtausschluß gelagert werden.

Die Kupferoberfläche von mit 35 µm starker Kupferfolie kaschierten Phenoplast-Schichtstoffplatten wird mechanisch mit Bimsmehl oder mit einer Bürstmaschine gereinigt und nach intensivem Abspülen mit Wasser mit ölfreier Luft trockengeblasen.

Auf die vorgereinigten Cu-Platten wird der Trockenresist — nach Abziehen der Deckfolie — mit Hilfe eines handelsüblichen Laminators bei 120°C und mit einer Geschwindigkeit von 1,5 m/min

auflaminiert.

Alle 20 Proben des auf die Kupferoberfläche laminierten Resists werden in je 3 Teile geteilt und anschließend durch die Trägerfolie unter einem 13stufigen Belichtungskeil mit Dichteinkrementen von 0,15 mit einer Metallhalogenidlampe von 5 kW jeweils 10, 20 und 40 Sekunden belichtet.

Die Keilstufe 0 entspricht einer optischen Dichte von 0,05 (Eigen-Absorption des Filmmaterials).

Nach Abziehen der Trägerfolie werden die Platten einer Sprühentwicklung mit 0,8%iger Sodalösung bei 25° C unterworfen. Die Entwicklungszeit beträgt ca. 60 Sekunden.

Um die Entwicklerresistenz zu prüfen — ein Test, um festzustellen, ob die Keilstufen voll vernetzt sind — wurden die 20 Sekunden belichteten Proben zusätzlich der 3fachen Entwicklungszeit — also 180 Sekunden unterworfen (Tabelle II, letzte Spalte).

Die voll vernetzten Keilstufen der entwickelten Trockenresistschichten wurden ausgezählt und in folgender Tabelle zusammengefaßt. In Klammern angegebene Stufenzahlen schließen nicht voll gedeckte, etwas vom Entwickler angegriffene Stufen mit ein.

Tabelle II

| Initiator Verbindung Nr. | Vollstufen 10 s. | 20 s. | 40 s. | Nach 180 Sekunden Entwicklung |
|---|---|---|---|---|
| 1 | 2 | 4 | 6 | 3 |
| 2 | 2 | 4 | 6 | 3 |
| 3 | 1 | 3 | 5 | 2 |
| 4 | 2 | 4 | 6 | 3 |
| 5 | 1 | 3 | 5 | 2 |
| 6 | 1 | 3 | 4 (5) | 2 |
| 7 | 2 | 4 | 6 | 3 |
| 8 | 3 | 5 | 7 | 4 |
| 9 | 1 | 3 | 5 | 2 |
| 10 | 4 | 6 | 8 | 5 |
| 11 | 0 | 0 | 1 | — |
| 12 | 4 | 6 | 8 | 5 |
| 13 | 3 | 5 | 7 | 4 |
| 14 | 0 | 1 | 2 | (1) |
| 15 | 1 | 3 | 5 | 2 |
| 16 | 2 | 4 | 6 | 3 |
| 17 | 0 | 1 | 2 | (1) |
| 18 | 0 | 1 | 3 | (1) |
| 19 | 1 | 2 | 4 | 1 |
| 20 | 0 | 0 | 1 | — |

Beispiel 2

Jeweils 0,4 g der Verbindungen 2, 4, 7, 8, 12 und 16 werden dem in Beispiel 1 beschriebenen photopolymerisierbaren Gemisch zugesetzt, und die Lösung wird auf eine 25 µm starke

Polyäthylenterephthalatfolie so aufgeschleudert, daß nach dem Trocknen eine 25 µm (30 $g/m^2$) dicke Schicht erhalten wird.

Die Schicht wird in gleicher Weise wie in Beispiel 1 auf die gereinigte Cu-Oberfläche einer 10 × 15 cm großen Cu-Schichtstoffplatte aufgebracht, durch die Trägerfolie belichtet und mit einer 0,8%igen wäßrigen Sodalösung entwickelt.

Es ergeben sich die aus der Tabelle III ersichtlichen vernetzten Keilstufen.

Tabelle III

| Verbindung Nr. | Vollstufen | | |
|---|---|---|---|
| | 10 Sek. | 20 Sek. | 40 Sek. |
| 2 | 4 | 6 | 8 |
| 4 | 3 | 6 | 8 |
| 7 | 3 | 5 | 7 |
| 8 | 5 | 7 | 9 |
| 12 | 4 | 7 | 9 |
| 16 | 3 | 5 | 7 |

Eine Erhöhung der Initiatorkonzentration über 0,4 g hinaus bringt in der Regel infolge Eigenabsorption des Starters keine Steigerung der Lichtempfindlichkeit mehr.

Beispiel 3

Eine Lösung aus

| | |
|---|---|
| 4,0 Gt | eines Mischpolymerisats aus Methylmethacrylat/Methacrylsäure (82 : 18) mit der Säurezahl 110, |
| 4,0 Gt | Trimethyloläthantriacrylat, |
| 0,08 Gt | des in Beispiel 1 angegebenen Farbstoffs und |
| 0,21 Gt | der Verbindung 7 in |
| 38 Gt | Glykolmonoäthyläther und |
| 18 Gt | Butylacetat |

wird auf elektrolytisch aufgerauhtes und durch Anodisierung gehärtetes 0,3 mm starkes Aluminium durch Aufschleudern so aufgetragen und getrocknet, daß ein Schichtgewicht von 2,5 $g/m^2$ erhalten wird.

Nach dem Trocknen wird die photopolymerisierbare Schicht mit einer Lösung von

| | |
|---|---|
| 5 Gt | Polyvinylalkohol mit dem K-Wert 8 und 12% unverseiften Acetylgruppen in |
| 95 Gt | entsalztem Wasser |

überschichtet und getrocknet, so daß eine abziehbare Deckschicht von 5 $g/m^2$ entsteht.

Anschließend wird mit der in Beispiel 1 angegebenen Lichtquelle 40 Sekunden unter einem 13stufigen Belichtungskeil belichtet.

Die belichtete Schicht wird ca. 1 Minute mittels eines Plüschtampons mit einem Entwickler aus

| | |
|---|---|
| 1,5 Gt | Natriummetasilikat · 9 $H_2O$, |
| 0,01 Gt | Fettalkoholpolyglykoläther und |
| 0,2 Gt | Strontiumchlorid · 6 $H_2O$ in |
| 98,3 Gt | entsalztem Wasser |

entwickelt. Dabei werden 5 volle Keilstufen erhalten.

Nach Wasserspülung wird mit 1%iger Phosphorsäure behandelt und mit handelsüblicher Fettfarbe eingefärbt.

Nach dem Einfärben wird gummiert und getrocknet. Auf einer Offsetdruckmaschine wurden Auflagen von 150 000 erzielt.

## Beispiel 4

Eine Beschichtungslösung aus

| | |
|---|---|
| 1,0 Gt | Trimethyloläthan-triacrylat, |
| 1,4 Gt | eines Terpolymerisats aus n-Hexylmethacrylat/Methylmethacrylat/Methacrylsäure (50 : 25 : 25) mit der Säurezahl 160, |
| 0,02 Gt | Methylviolett (C.I. 42 535) und |
| 0,05 Gt | Verbindung 12 in |
| 6,0 Gt | Butanon |

wird auf eine gesäuberte Einstufen-Zinkätzplatte so aufgeschleudert und getrocknet, daß ein Schichtgewicht von ca. 10 g/m² erhalten wird.

Anschließend wird das Kopiermaterial mit einem 1 – 2 μm dicken Überzug von Polyvinylalkohol versehen, getrocknet und 40 Sekunden unter einer Positiv-Vorlage mit der in Beispiel 1 angegebenen Lichtquelle belichtet. Die Zinkplatte wird 45 Sekunden mit einem Entwickler aus

| | |
|---|---|
| 1,5 Gt | Natriummetasilikat-Nonahydrat, |
| 0,3 Gt | Polyäthylenglykol mit dem mittleren Molgewicht 6000, |
| 0,3 Gt | Lävulinsäure und |
| 0,3 Gt | Strontiumhydroxid-Octahydrat und |
| 97,6 Gt | entsalztem Wasser |

entwickelt.

Nach gründlicher Wasserspülung wird 5 Minuten mit 10%iger Salpetersäure unter Zusatz von Flankenschutzmittel geätzt. Die gehärtete Photopolymerschicht wird mit Äthylenglykolmonobutyläther entfernt. Die so entstandene Druckform eignet sich für den Qualitätsbuchdruck.

## Beispiel 5

Eine Beschichtungslösung, wie in Beispiel 4 beschrieben, jedoch mit 0,05 Gt der Verbindung 16 anstelle von Verbindung 12 wird auf eine 25 μm starke Polyäthylenterephthalatfolie durch Gießen aufgetragen. Anschließend wird 2 Minuten bei 100°C im Trockenschrank nachgetrocknet. Es wird eine 20 μm (26 g/m²) dicke Schicht erhalten.

Die getrocknete Schicht wird zusammen mit der Polyesterfolie mittels eines handelsüblichen Laminators bei höchstem Andruck und einer Temperatur von 115°C mit einer Geschwindigkeit von 1 m/min auf ein handelsübliches Siebdruckgewebe auflaminiert.

Anschließend wird durch die Polyesterfolie 60 Sekunden mit der in Beispiel 1 angegebenen Lichtquelle unter einer Positiv-Vorlage belichtet.

Nach Abziehen der Polyesterfolie werden mit dem in Beispiel 4 beschriebenen Entwickler 45 Sekunden im Schaukelbad die unvernetzten Bildbereiche entfernt. Nach gründlicher Wasserspülung und Trocknung ist die Siebdruckform gebrauchsfertig.

## Beispiel 6

Eine Lösung folgender Zusammensetzung:

| | |
|---|---|
| 1,0 Gt | Trimethyloläthantriacrylat, |
| 1,4 Gt | des in Beispiel 4 beschriebenen Terpolymerisats, |
| 0,02 Gt | des in Beispiel 1 angegebenen Farbstoffs und |
| 0,05 Gt | der Verbindung 8 in |
| 8,0 Gt | Butanon |

wird auf eine vorher mit Wasser und Trichloräthylen gereinigte Trimetallplatte (Fe/Cu/Cr) aufgeschleudert. Anschließend wird die Schicht 2 Minuten bei 100°C nachgetrocknet. Es wird eine Schichtdicke von ca. 10 μm erhalten.

In einem zweiten Arbeitsschritt wird die lichtempfindliche Schicht mit einer 3%igen wäßrigen Polyvinylalkohol-Lösung überschichtet und getrocknet, so daß eine etwa 4 μm starke Deckschicht entsteht.

Nach einer Belichtungszeit von 120 Sekunden mit der in Beispiel 1 angegebenen Lichtquelle unter einer Negativ-Vorlage wird 60 Sekunden mit dem in Beispiel 4 beschriebenen Entwickler im Schaukelbad entwickelt.

Anschließend wird die lichtgehärtete Schicht noch 10 Minuten bei 100° C nachgetempert.

Danach wird das freigelegte Chrom mit einer Lösung aus 17,4% $CaCl_2$, 35,3% $ZnCl_2$, 2,1% HCl und 45,2% Wasser innerhalb von 5 Minuten weggeätzt und die gehärtete Photopolymerschicht mit Methylenchlorid entfernt.

Anschließend wird mit 1%iger Phosphorsäure überwischt und mit Fettfarbe eingefärbt. Die Trimetallplatte ist damit druckfertig.

## Patentansprüche

1. Photopolymerisierbares Gemisch, das ein polymeres Bindemittel, eine polymerisierbare Verbindung mit mindestens einer endständigen äthylenischen Doppelbindung und einem Siedepunkt oberhalb 100°C sowie eine mehrkernige heterocyclische Verbindung als Photoinitiator enthält, dadurch gekennzeichnet, daß der Photoinitiator eine Verbindung der Formel

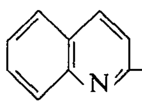

$-(CH=CH)_n-R$

ist, worin

R ein gegebenenfalls durch Alkoxy-, Alkyl-, Aryl-, Hydroxy-, Carbonsäureamidgruppen oder Halogenatome substituierter aromatischer Rest und

n 1 oder 2 ist.

2. Photopolymerisierbares Gemisch nach Anspruch 1, dadurch gekennzeichnet, daß es 0,01 bis 10 Gew.-% des Photoinitiators, bezogen auf die Menge der polymerisierbaren Verbindung, enthält.

3. Photopolymerisierbares Gemisch nach Anspruch 1, dadurch gekennzeichnet, daß $n=1$ und R ein Methoxyphenyl-, Methylphenyl-, Naphthyl-(1)-, Phenanthryl-(3)- oder Benzo[2]thienyl-(3)-rest ist.

4. Photopolymerisierbares Gemisch nach Anspruch 1, dadurch gekennzeichnet, daß $n=2$ und R ein Phenylrest ist.

5. Photopolymerisierbares Gemisch nach Anspruch 1, dadurch gekennzeichnet, daß das polymere Bindemittel wasserunlöslich und in wäßrig-alkalischen Lösungen löslich ist.

6. Photopolymerisierbares Gemisch nach Anspruch 1, dadurch gekennzeichnet, daß die polymerisierbare Verbindung ein Acryl- oder Methacrylsäureester mit mindestens zwei polymerisierbaren Gruppen ist.

## Claims

1. A photopolymerizable mixture which contains a polymeric binder, a polymerizable compound having at least one terminal ethylenic double bond and a boiling point above 100° C, and a polynuclear heterocyclic compound as photoinitiator, characterized in that the photoinitiator is a compound having the formula

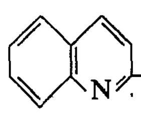

$-(CH=CH)_n-R$

wherein

R is an aromatic group which may be substituted by alkoxy, alkyl, aryl, hydroxy or carboxylic acid amide groups or by halogen atoms and

n is 1 or 2.

2. A photopolymerizable mixture as claimed in claim 1, characterized in that it contains from 0.01 to 10 per cent by weight of the photoinitiator, relative to the quantity of the polymerizable compound.

3. A photopolymerizable mixture as claimed in claim 1, characterized in that $n=1$ and R is a methoxyphenyl, methylphenyl, naphthyl-(1), phenanthryl-(3) or benzo[2]thienyl-(3) group.

4. A photopolymerizable mixture as claimed in claim 1, characterized in that $n=2$ and R is a phenyl group.

5. A photopolymerizable mixture as claimed in claim 1, characterized in that the polymeric binder is

insoluble in water and is soluble in aqueous alkaline solutions.

6. A photopolymerizable mixture as claimed in claim 1, characterized in that the polymerizable compound is an acrylic or methacrylic acid ester having at least two polymerizable groups.

## Revendications

1. Mélange photopolymérisable qui contient un liant polymère, un composé polymérisable présentant au moins une double liaison éthylénique terminale et ayant un point de fusion supérieur à 100°C ainsi qu'un composé hétérocyclique polycyclique comme photo-amorceur, caractérisé en ce que le photo-amorceur est un composé de la formule:

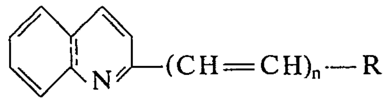

dans laquelle:

R est un radical aromatique éventuellement substitué par des groupes alcoxyle, alkyle, aryle, hydroxyle ou carboxamide ou des atomes d'halogène et

n est égal à 1 ou 2.

2. Mélange photopolymérisable selon la revendication 1, caractérisé en ce qu'il contient 0,01 à 10% en poids du photo-amorceur, par rapport à la quantité du composé polymérisable.

3. Mélange photopolymérisable selon la revendication 1, caractérisé en ce que $n=1$ et que R est un radical méthoxyphényle, méthylphényle, naphtyle (1), phénantryle (3) ou benzo [2] thiényle (3).

4. Mélange photopolymérisable selon la revendication 1, caractérisé en ce que $n=2$ et que R est un radical phényle.

5. Mélange photopolymérisable selon la revendication 1, caractérisé en ce que le liant polymère est insoluble dans l'eau et soluble dans les solutions alcalines aqueuses.

6. Mélange photopolymérisable selon la revendication 1, caractérisé en ce que le composé polymérisable est un ester d'acide acrylique ou méthacrylique contenant au moins deux groupes polymérisables.